# EUROPÄISCHE PATENTANMELDUNG

(11) **EP 4 651 650 A1**
(43) Veröffentlichungstag der Anmeldung: **19.11.2025**
(21) Anmeldenummer: 25175383.6
(22) Anmeldetag: 09.05.2025
(51) Int. Cl.: H05K 5/02

(54) **ELEKTRONIKGEHÄUSE FÜR EINE ROTATIONSMASCHINE SOWIE ROTATIONSMASCHINE, INSBESONDERE PUMPE, MIT EINEM SOLCHEN ELEKTRONIKGEHÄUSE**

(30) Priorität: 15.05.2024 DE 102024113596
(71) Anmelder: KSB SE & Co. KGaA, 67227 Frankenthal (DE)
(72) Erfinder: KRILL, David, 67227 Frankenthal (DE); Rosché, Pascal, 67227 Frankenthal (DE)

(57) **Zusammenfassung**

Die Erfindung betrifft ein Elektronikgehäuse für eine Rotationsmaschine, insbesondere für eine Pumpe, bestehend aus einem Gehäusekorpus und einem Gehäusedeckel, der mittels wenigstens eines Scharniers schwenkbar am Gehäusekorpus befestigt ist, dadurch gekennzeichnet, dass das wenigstens eine Scharnier ein Mehrfachscharnier mit wenigstens zwei Schwenkachsen ist und der Gehäusedeckel im geöffneten Zustand an eine Fläche des Gehäusekorpus anlegbar ist, so dass der Gehäusedeckel in der geöffneten Endstellung in seiner Position verbleibt.

## Beschreibung

Die Erfindung betrifft ein Elektronikgehäuse für eine Rotationsmaschine, insbesondere für eine Pumpe, bestehend aus einem Gehäusekorpus und einem Gehäusedeckel, der mittels wenigstens eines Scharniers schwenkbar am Gehäusekorpus befestigt ist.

Die notwendige Elektronik für die Ansteuerung bzw. Regelung von Rotationsmaschinen wie Pumpen, insbesondere Heizungsumwälzpumpen, ist üblicherweise in einem gesonderten Elektronikgehäuse untergebracht, das entweder am Pumpen- bzw. Motorgehäuse der Maschine montiert ist oder separat von der Pumpe installiert wird. Neben den elektronischen Bausteinen für die Steuerung/Regelung können Anschlussstellen für den Anschluss externer Versorgungs- oder Signalleitungen sowie Anzeige- und/oder Bedienelemente im Gehäuse aufgenommen sein. Für die Inbetriebnahme der Maschine bzw. zu Wartungs- oder Reparaturzwecken muss das Elektronikgehäuse geöffnet werden, was durch einen abnehmbaren Gehäusedeckel möglich ist.

Oftmals sind aus Platzgründen und aus Gründen der besseren Zugänglichkeit Anzeige- und Bedienelemente direkt in den Gehäusedeckel integriert. Beim Öffnen des Gehäusedeckels muss darauf geachtet werden, dass etwaige Verbindungsleitungen zwischen der Elektronik im Deckel und der Elektronik im Gehäusekorpus nicht beschädigt werden, d.h. der Deckel kann entweder nicht vollständig vom Gehäusekorpus entfernt und bei Seite gelegt werden, oder aber die Verbindungsleitungen müssen vorab getrennt werden.

Es wird daher nach einer geeigneten Lösung für die Ausführung eines Elektronikgehäuses gesucht, die das Öffnen des Elektronikgehäuses vereinfacht, jedoch auch einfach und kostengünstig zu realisieren ist.

Gelöst wird diese Aufgabe durch ein Elektronikgehäuse gemäß den Merkmalen des Anspruchs 1. Vorteilhafte Ausführungen des Elektronikgehäuses sind Gegenstand der abhängigen Ansprüche.

Erfindungsgemäß wird vorgeschlagen, den Gehäusedeckel des Elektronikgehäuses über wenigstens ein Mehrfachscharnier mit dem Gehäusekorpus zu verbinden. Als Mehrfachscharnier wird ein Scharnier mit wenigstens zwei separaten Schwenkachsen bezeichnet, die bevorzugt parallel und versetzt zueinander verlaufen. Die Verwendung eines Mehrfachscharniers gestattet einen größeren Schwenkbereich des Deckels, so dass dieser nicht nur geöffnet, sondern auch bis zu einer geeigneten Anschlagfläche des Gehäusekorpus aufgeschwenkt werden kann. Erfindungsgemäß ist vorgesehen, dass der Gehäusedeckel in seiner geöffneten Endstellung an eine Fläche des Gehäusekorpus anlegbar ist, so dass der Gehäusedeckel in der geöffneten Endstellung nur durch seine Gewichtskraft in der geöffneten Stellung gehalten wird. Eine separate Arretierungsvorrichtung ist demzufolge unnötig.

Idealerweise kann der Gehäusedeckel in der geöffneten Endstellung auf der Oberseite des endmontierten Elektronikgehäuses abgelegt werden. Bevorzugt gestattet das verbaute Mehrfachscharnier einen Schwenkwinkel von mehr als 180 Grad zwischen der geschlossenen Stellung und der geöffneten Endstellung, besonders bevorzugt wird ein Schwenkwinkel von mehr als 220 Grad erreicht, idealerweise von etwa 270 Grad.

Das Elektronikgehäuse kann an einem Pumpengehäuse montierbar sein. Es ist ebenso vorstellbar, dass mittels des Elektronikgehäuses ein zentrales Schaltgerät für ein oder mehrere Pumpen realisiert ist, d.h. das Elektronikgehäuse separat von der oder den anzusteuernden Pumpen installiert ist.

Denkbar ist eine Realisierung des Mehrfachscharniers als Doppelscharnier mit zwei parallelen und zueinander versetzt liegenden Schwenkachsen. Grundsätzlich kann der Gehäusedeckel mit nur einem Mehrfachscharnier am Korpus angelenkt sein, stabiler ist jedoch die Verwendung von mindestens zwei Mehrfachscharnieren, deren Schwenkachsen fluchtend zueinander liegen. Besonders bevorzugt ist eine Anlenkung der Mehrfachscharniere im Eckbereich des Gehäusedeckels und/oder Gehäusekorpus.

Bevorzugt ist es weiterhin, wenn über eine erste Schwenkachse eine Schwenkbewegung des Gehäusedeckels relativ zum Mehrfachscharnier ermöglicht wird, während über eine zweite Schwenkachse eine Schwenkbewegung des Mehrfachscharniers relativ zum Gehäusekorpus erfolgt.

Besonders bevorzugt ist es, wenn das Mehrfachscharnier zusätzlich zu den Schwenkbewegungen um die wenigstens zwei Schwenkachsen eine translatorische Bewegung des Gehäusedeckels zum Gehäusekorpus zulässt. D.h. die translatorische Bewegung des Gehäusedeckels kann ohne überlagerte Schwenkbewegung ausgeführt werden. **In** Abhängigkeit der zu erfüllenden Schutzart muss der Gehäusedeckel im geschlossenen Zustand über den gesamten Öffnungsrand dichtend am Gehäusekorpus anliegen. Gegebenenfalls kann dies eine relative Schwenkbewegung zunächst erschweren oder gar blockieren, so dass mittels des zusätzlichen Freiheitsgrades des Mehrfachscharniers zunächst eine translatorische Bewegung des Gehäusedeckels ausgeführt werden kann. Dadurch lässt sich zunächst der Abstand zwischen Gehäusedeckel und Gehäusekorpus vergrößern, um dann ausreichend Raum für die Schwenkbewegungen um die wenigstens zwei Schwenkachsen zu haben.

Bevorzugt erlaubt das Mehrfachscharnier eine translatorische Bewegung entlang einer imaginären Verbindungsachse der beiden Schwenkachsen. Beispielsweise erfolgt durch die translatorische Bewegung eine Verschiebung wenigstens einer Schwenkachse relativ zum Gehäusekorpus. Eine solche translatorische Verstellung der Schwenkachse kann bspw. durch ein Langloch realisiert sein, in dem ein Gelenkteil, bspw. ein Zapfen, Bolzen oder Stift, zur Umsetzung der Schwenkachse aufgenommen ist. Bevorzugt weist der Gehäusekorpus ein solches Langloch auf, das als Aufnahme eines passenden Zapfens des Scharniers dient. Der Zapfen kann innerhalb des Langloches relativ zum Gehäusekorpus in einer definierten Richtung, idealerweise auf der Verbindungsachse der beiden Schwenkachsen, verschoben werden.

Gemäß einer weiterhin bevorzugten Ausführungsform kann vorgesehen sein, dass das wenigstens eine Mehrfachscharnier ein lösbar mit dem Gehäusekorpus und dem Gehäusedeckel verbindbares Verbindungsteil umfasst. Ein solches Verbindungsteil kann wenigstens zwei auskragende Scharnierzapfen zur Ausbildung der wenigstens zwei Scharnierschwenkachsen umfassen. Die Scharnierzapfen sind in entsprechende Zapfenaufnahmen im Gehäusedeckel sowie Gehäusekorpus steckbar. Idealerweise lässt sich ein solches Verbindungsteil werkzeugfrei in den Gehäusedeckel und den Gehäusekorpus einbringen und/oder von diesen entfernen, wodurch der Gehäusedeckel bei Bedarf auch vollständig vom Gerätekorpus getrennt werden kann.

Vorstellbar ist es zu diesem Zweck, wenn wenigstens einer der Scharnierzapfen endseitig eine umlaufende Wulst aufweist. Die umlaufende Wulst wirkt wie ein Widerhaken und dient zur Sicherung des Zapfens in der zugehörigen Zapfenaufnahme des Gehäusedeckels bzw. des Gehäusekorpus.

Das Verbindungsteil des Mehrfachscharniers fügt sich vorteilhafterweise in seiner Montageposition, d.h. bei eingesteckten Scharnierzapfen, optisch in die Außenkontur des Elektronikgehäusekorpus ein.

Vorstellbar ist es zudem, wenn wenigstens einer der Scharnierzapfen eine abgeflachte Profilform aufweist. Die abgeflachten Teilflächen des Zapfenprofils dienen als Führungsflächen innerhalb des Langloches für die translatorische Bewegung, d.h. die abgeflachten Profilflächen gleiten auf den Langflächen des Langloches. Wenigstens einer der Scharnierzapfen kann auch mit einer geriffelten Zapfenfläche ausgeführt sein. Aufgrund der geriffelten Oberfläche wird das Risiko des Anhaftens des Zapfens innerhalb der Zapfenaufnahme minimiert. Auch kann die geriffelte Oberfläche für bessere Gleiteigenschaften während der translatorischen Bewegung dienlich sein. Das Verbindungsteil sowie die Scharnierzapfen können aus Kunststoff oder einem elastischen Material, bspw. einem Elastomer, hergestellt sein. Denkbar ist es auch, dass wenigstens einer der Scharnierzapfen aus zwei beabstandeten Halbteilen aufgebaut ist, die beim Einstecken in die Zapfenaufnahme zusammengedrückt werden. Bei einer Fertigung des Verbindungsteils aus elastischem Material können der oder die Zapfen auch als Vollprofil ausgeführt sein.

Wie es bereits zuvor angedeutet wurde, können zwischen Gehäusekorpus und Gehäusedeckel ein oder mehrere Dichtungselemente eingesetzt sein, um eine definierte Schutzart, bspw. IPX4 zu erfüllen. In den Gehäusedeckel können ein oder mehrere Elektronikkomponenten integriert bzw. eingebettet sein, so beispielsweise wenigstens ein Anzeige- und/oder Bedienelement zur Steuerung/Bedienung der Rotationsmaschine. Die Elektronikkomponenten im Deckel sind über wenigstens ein Kabel, insbesondere ein Flachbandkabel, mit der Elektronik im Gehäusekorpus elektrisch verbunden, wobei diese Verbindung über den gesamten Schwenkbereich bestehen bleibt.

Neben dem erfindungsgemäßen Elektronikgehäuse betrifft die vorliegende Erfindung auch eine Rotationsmaschine, insbesondere eine Pumpe, bevorzugt eine Kreiselpumpe, mit einem am Maschinengehäuse bzw. Pumpengehäuse montierten Elektronikgehäuse gemäß der Erfindung. Demzufolge weist die beanspruchte Maschine dieselben Vorteile und Eigenschaften aus, wie sie bereits vorstehend anhand des erfindungsgemäßen Elektronikgehäuses aufgezeigt wurden. Auf eine wiederholende Beschreibung wird aus diesem Grund verzichtet. Alternativ ist auch ein System bestehend aus wenigstens einer Rotationsmaschine, bevorzugt Pumpe, besonders bevorzugt Kreiselpumpe, und dem erfindungsgemäßen Elektronikgehäuse vorstellbar, wobei das Elektronikgehäuse extern zur wenigstens einen Rotationsmaschine angeordnet und zur Steuerung/Regelung/Schaltung der wenigstens einen Rotationsmaschine dient.

Weitere Vorteile und Eigenschaften der Erfindung sollen nachfolgend anhand eines in den Figuren dargestellten Ausführungsbeispiels näher erläutert werden. Es zeigen:
- Figur 1:: eine perspektivische Seitenansicht auf die als Heizungsumwälzpumpe ausgeführte erfindungsgemäße Rotationsmaschine mit dem erfindungsgemäßen Elektronikgehäuse,
- Figur 2:: eine Seitenansicht auf das Elektronikgehäuse,
- Figur 3:: eine Schnittdarstellung durch das Elektronikgehäuse im Bereich eines Doppelscharniers,
- Figuren 4a. 4b:: Detailansichten eines ersten Ausführungsbeispiels des Doppelscharniers,
- Figuren 5a-6b:: alternative Ausführungen des Doppelscharniers,
- Figuren 7 - 11:: unterschiedliche perspektivische Darstellungen des Elektronikgehäuses während des Öffnen des Gehäusedeckels in chronologischer Reihenfolge und
- Figuren 12a, 12:: Detailansichten des Elektronikgehäuses im Bereich der Aufnahme des Doppelscharniers.

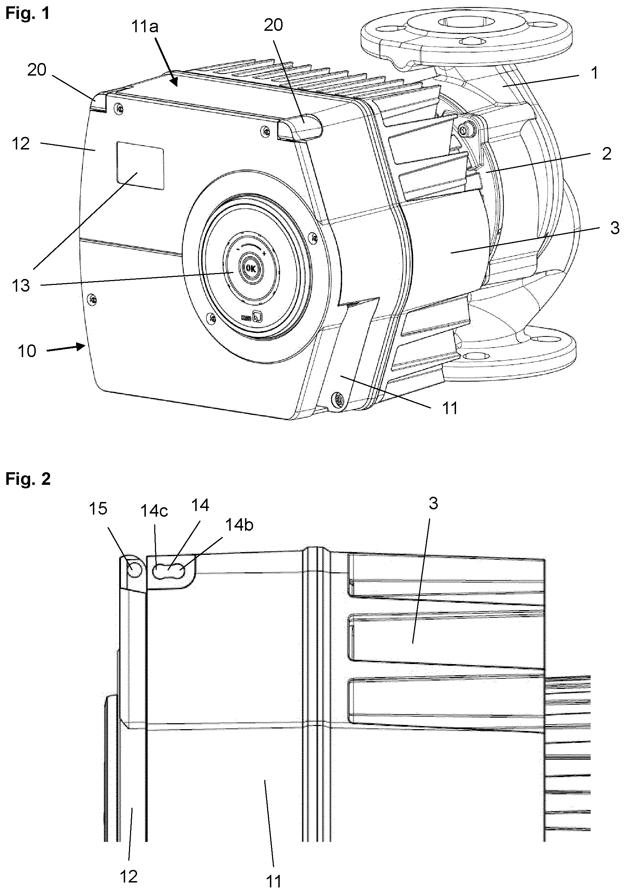

Figur 1 zeigt eine perspektivische Ansicht einer als Heizungsumwälzpumpe ausgeführten Rotationsmaschine. Der Hydraulikteil der Pumpe ist mit dem Bezugszeichen 1 gekennzeichnet. Auf dem am Hydraulikteil 1 sitzenden elektrischen Antriebsmotor 2 ist ein Kühlkörper 3 montiert, der die Unterseite des Elektronikgehäuses 10 bildet. Das Elektronikgehäuse 10 ist aus Kunststoff gefertigt und besteht aus zwei Teilen, nämlich dem Gehäusekorpus 11 sowie dem Gehäusedeckel 12. Auf dem Deckel 12 sind elektronische Anzeige- und Bedienelemente 13 angeordnet, die eine Steuerung der Pumpe sowie das Ablesen etwaiger Pumpenparameter von außen möglich machen.

Der Deckel 12 des Elektronikgehäuses 10 kann zu Wartungs- bzw. Installationsarbeiten geöffnet werden, um die Elektronik der Pumpe mit externen Signal- und Versorgungsleitungen zu verbinden. Zu diesem Zweck ist das Elektronikgehäuse 10 mit einem neuartigen Scharniermechanismus ausgestattet, der eine Schwenkbewegung des Gehäusedeckels 12 gegenüber dem Gehäusekorpus 11 nach oben um mehr als 180 Grad gestattet. Bei der hier dargestellten Ausführung kann der Deckel 12 um etwa 270 verschwenkt werden, wodurch der Deckel 12 im geöffneten Endzustand auf die Oberseite 11a des Gehäusekorpus 11 sowie des Kühlkörpers 3 abgelegt werden kann.

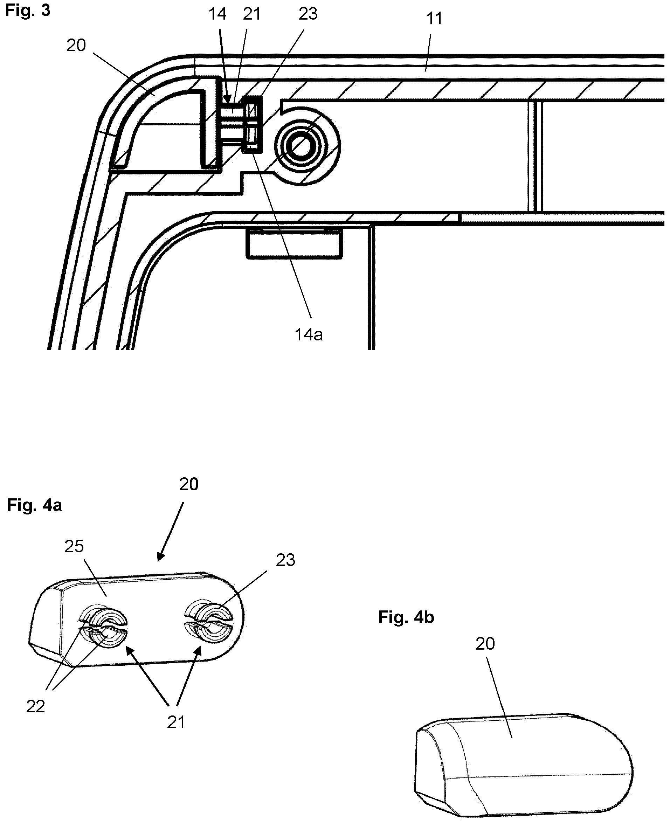

Die Schwenkbewegung wird mittels zwei Doppelscharnieren 20 realisiert, die an den zwei oberen Eckbereichen des Elektronikgehäuses 10 eingesetzt sind und den Deckel 12 mit dem Gerätekorpus 11 schwenkbar verbinden. Es wird auf die Figuren 2 und 3 verwiesen. Dazu umfasst der Gerätekorpus 11 pro Doppelscharnier 20 jeweils ein Langloch 14, das als Zapfenaufnahme für den ersten Scharnierzapfen 21 des Verbindungsteils 25 des jeweiligen Doppelscharniers 20 dient. Ebenso umfasst der Deckel 12 pro Doppelscharnier 20 jeweils eine Bohrung 15, die als zweite Zapfenaufnahme für den zweiten Scharnierzapfen 21 des Verbindungselements 25 dient. Das Verbindungsteil 25 kann von außen mit seinen Zapfen 21 in die entsprechenden Bohrungen 14, 15 eingesteckt werden, um den Deckel 12 schwenkbar mit dem Gehäusekorpus 11 zu verbinden. Das Einsetzen des Verbindungsteils 25 kann ohne Werkzeug erfolgen. Auch kann das Verbindungsteil 25 werkzeuglos unter Einsatz einer erhöhten Zugkraft entfernt werden, um den Deckel 12 vollständig vom Gehäuse 11 zu demontieren.

Wie dies beispielsweise einer ersten Ausführungsform des Verbindungsteils 25 gemäß der Figuren 4a, 4b zu entnehmen ist, können die Zapfen 21 endseitig eine um ihre Außenkontur umlaufende Wulst 23 zur Ausbildung eines Widerhakens aufweisen. Die Wulst 23 liegt im montierten Zustand des Scharniers 20 in einem Bodenabschnitt 14a der Bohrungen 14, 15, der einen gegenüber dem restlichen Teilabschnitt der Bohrungen 14, 15 vergrößerten Durchmesser zur Aufnahme der Wulst 23 aufweist. Beim Herausziehen der Zapfen 21 schlägt die Wulst 23 an die resultierende Kante der Durchmesserverjüngung der Bohrung 14, 15 an, so dass ein unbeabsichtigtes Herausziehen der Doppelscharniere 20 vermieden wird bzw. nur unter erhöhter Kraftaufbringung möglich ist.

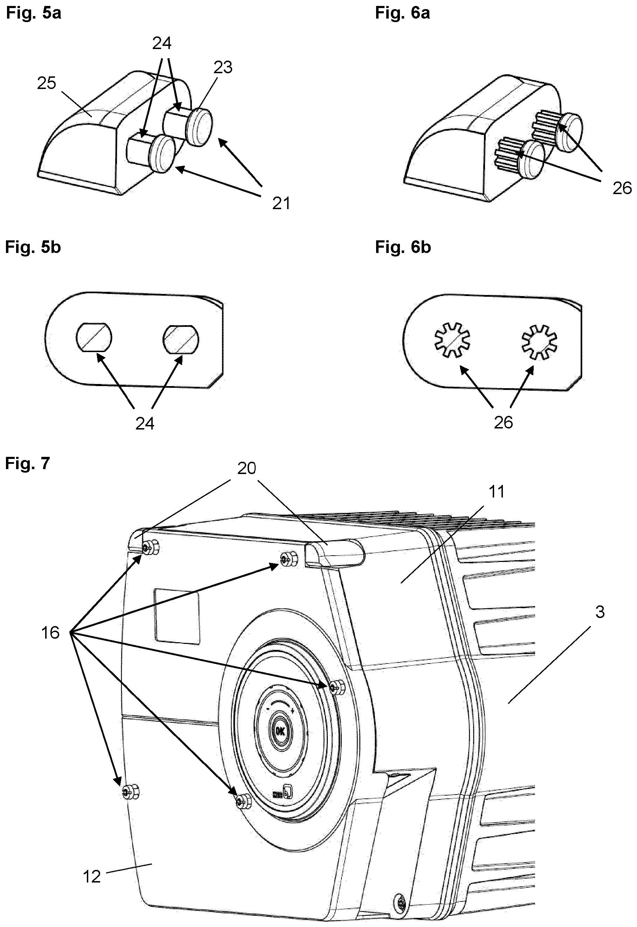

Um die Zapfen 21 mit der Wulst 23 in die Bohrungen 14, 15 einstecken zu können, müssen diese elastisch verformbar sein. Eine Möglichkeit zur Realisierung besteht darin, die Zapfen 21 jeweils durch zwei symmetrische Halbschalen 22 zu bilden (siehe Figuren 4a, 4b), die beabstandet zueinander von dem Verbindungsteil 25 auskragen und beim Einbringen in die zugehörigen Zapfenaufnahmen 14, 15 zusammengedrückt werden können. Alternativ können die Doppelscharniere 20 auch aus einem elastischen Material wie Gummi bestehen (siehe Figuren 5a, 5b, 6a, 6b), so dass eine Ausführung der Zapfen 21 als Vollprofil möglich ist.

Den Ausführungsbeispielen der Figuren 5a, 5b und 6a, 6b sind zudem unterschiedliche Profilformen der Zapfen 21 zu entnehmen, beispielsweise in Figur 5a ein abgeflachtes Profil mit ebenen Flächenabschnitten 24. Diese ebenen Flächenabschnitte 24 bilden die Gleitflächen, die die Langflächen des Langloches 14 kontaktieren und dadurch eine bessere Führung des Zapfens 21 bei einer translatorischen Verschiebung innerhalb des Langloches 14 sicherstellen. Die Ausführung der Zapfen 21 mit geriffelter Oberfläche 26 gemäß der Figur 6a kann ein störendes Anhaften der Zapfenfläche an der Innenseite der Bohrungen 14, 15 und damit eine unerwünschte Reibkraft beim Schwenken des Deckels 12 reduzieren.

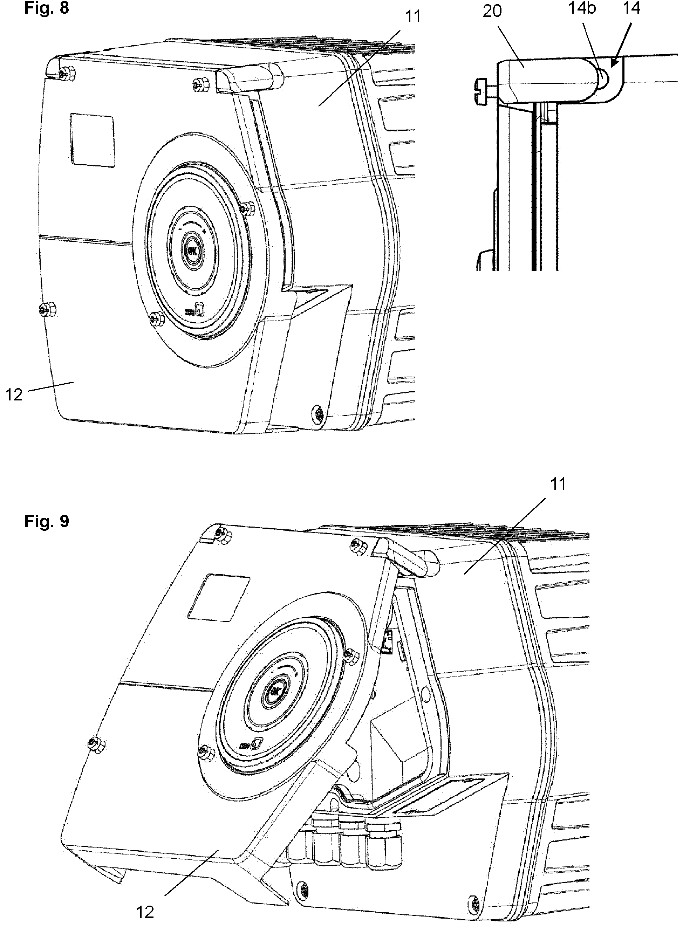

Figur 7 zeigt nunmehr den Ausgangszustand des Elektronikgehäuses 10 mit geschlossenem Deckel 12. Zum Öffnen des Deckels 12 werden die Schrauben 16 zunächst gelöst. Die Schrauben 16 sind verliersicher und verbleiben am Deckel 12. Nach dem Lösen der Schraubenverbindungen kann der Deckel 12 über die translatorische Bewegung des Doppelscharniers 20 bzw. des Verbindungsteils 25 vom Gehäusekorpus 11 wegbewegt werden, sodass sich insgesamt der Abstand zwischen Deckel 12 und Korpus 11 vergrößert. Siehe dazu Figur 8. Erreicht wird dies durch eine Linearbewegung der im Langloch 14 befindlichen Zapfen 21, die von einer ersten Endposition 14b zu einer zweiten Endposition 14c wandern. Das Langloch 14 hat zwischen den Endpositionen 14b, 14c eine leicht reduzierte Weite, wodurch der Zapfen

21 in den Endpositionen 14b, 14c zum einen gesichert wird und dem Bediener zum anderen beim Erreichen einer der Endpositionen auch eine haptische Rückmeldung vermittelt.

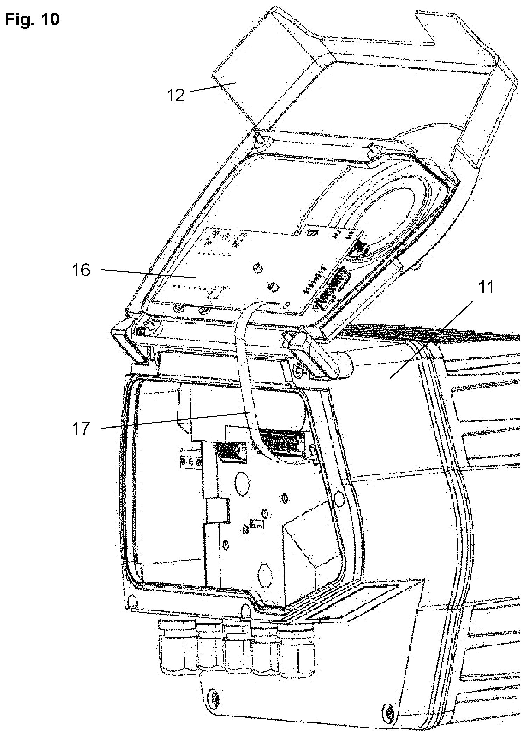

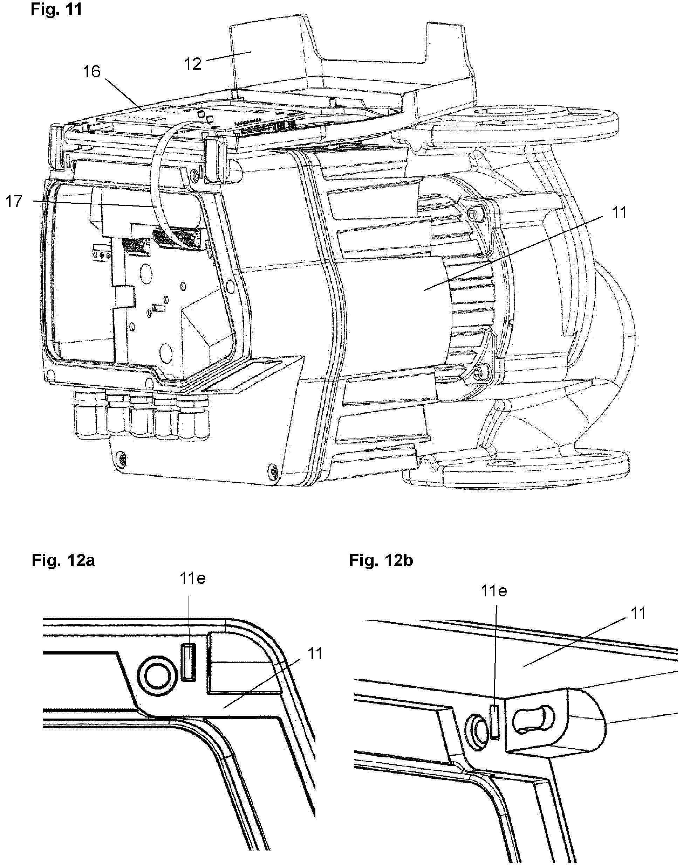

Nach der translatorischen Bewegung kann der Deckel 12 über die beiden Schwenkachsen des Doppelscharniers 20 nach oben verschwenkt werden. Dazu wird zunächst eine Schwenkbewegung durch Rotation des ersten, im Langloch 14 des Gehäusekorpus 11 aufgenommenen Zapfens 21 realisiert (siehe Figur 9), woran sich eine Schwenkbewegung durch Rotation des zweiten, in der Bohrung 15 des Deckels 12 aufgenommenen Zapfens 21 anschließt (Figur 10), bis der Deckel 12 um etwa 270 Grad geöffnet und auf der Oberseite 11 des Elektronikgehäuses bzw. des Kühlkörpers 3 abgelegt werden kann (Figur 12). Eine für die Realisierung der Anzeige- und Bedienelemente 13 innen am Gehäusedeckel 12 befestigte Elektronikplatine 16 im Gehäusedeckel 12 bleibt mit der Hauptelektronik innerhalb des Gehäusekorpus 11 über das Flachbandkabel 17 während der gesamten Schwenkbewegung elektrisch verbunden, sodass zum Öffnen des Gehäusedeckels 12 keinerlei elektrischen Verkabelungsarbeiten vorgenommen werden müssen.

Zum Verschließen des Deckels 12 werden die in den Figuren 7 - 11 gezeigten Schritte in umgekehrter Reihenfolge ausgeführt.

Das Elektronikgehäuse wird per Spritzguss aus Kunststoff hergestellt. Das Langloch 14 wird beispielsweise durch einen Schieber innerhalb des Spritzgusswerkzeuges realisiert. Die Bodenbereich 14a des Langloches 14 mit vergrößerten Durchmesser wird durch einen weiteren Schieber realisiert, der quer zur Langlochbohrung 14 eingesetzt wird und der ursächlich für die in Figur 12a, 12b gezeigte Aussparung 11e an der Stirnseite der Gehäuseöffnung ist.

## Patentansprüche

1. Elektronikgehäuse (10) für eine Rotationsmaschine, insbesondere Pumpe, bestehend aus einem Gehäusekorpus (11) und einem Gehäusedeckel (12), der mittels wenigstens eines Scharniers (20) schwenkbar am Gehäusekorpus (11) befestigt ist,
**dadurch gekennzeichnet,**
**dass** das wenigstens eine Scharnier (20) ein Mehrfachscharnier mit wenigstens zwei Schwenkachsen ist und der Gehäusedeckel (12) im geöffneten Zustand an eine Fläche (11a) des Gehäusekorpus (11) anlegbar ist, so dass der Gehäusedeckel (12) in der geöffneten Endstellung in seiner Position verbleibt.

2. Elektronikgehäuse (10) nach Anspruch 1, **dadurch gekennzeichnet, dass** der Gehäusedeckel (12) um mehr als 180° gegenüber dem Gehäusekorpus (11) verschwenkbar ist.

3. Elektronikgehäuse (10) nach einem der vorstehenden Ansprüche, **dadurch gekennzeichnet, dass** das wenigstens eine Mehrfachscharnier (20), insbesondere ein Doppelscharnier, neben den Schwenkbewegungen um die wenigstens zwei Schwenkachsen eine translatorische Bewegung des Gehäusedeckels (12) zum Gehäusekorpus (12) ermöglicht.

4. Elektronikgehäuse (10) nach Anspruch 3, **dadurch gekennzeichnet, dass** die translatorische Bewegung entlang einer Verbindungsachse der beiden Rotationsachsen möglich ist.

5. Elektronikgehäuse (10) nach einem der Ansprüche 3 oder 4, **dadurch gekennzeichnet, dass** die translatorische Bewegung durch eine Verschiebung einer Schwenkachse des wenigstens einen Mehrfachscharniers (20) relativ zum Gehäusekorpus (11) erfolgt.

6. Elektronikgehäuse (10) nach Anspruch 5, **dadurch gekennzeichnet, dass** die Verschiebung der Schwenkachse zum Gehäusekorpus (11) durch ein Langloch (14) innerhalb des Gehäusekorpus (11) zur Aufnahme eines die Schwenkachse ausbildenden Scharnierzapfens (21) ermöglicht ist.

7. Elektronikgehäuse (10) nach einem der Ansprüche 2 bis 6, **dadurch gekennzeichnet, dass** durch die translatorische Bewegung ausgehend von der geschlossenen Deckelstellung der Abstand zwischen Gehäusedeckel (11) und Gehäusekorpus (12) vergrößerbar ist.

8. Elektronikgehäuse (10) nach einem der vorstehenden Ansprüche, **dadurch gekennzeichnet, dass** das wenigstens eine Mehrfachscharnier (20) ein lösbar mit dem Gehäusekorpus (11) und dem Gehäusedeckel (11) verbindbares Verbindungsteil (25) umfasst, wobei das Verbindungsteil (25) wenigstens zwei auskragende Scharnierzapfen (21) umfasst, die zur Ausbildung der wenigstens zwei Scharnierschwenkachsen in zugehörige Zapfenaufnahmen (14, 15) des Gehäusedeckels (12) und Gehäusekorpus (12) einsteckbar sind.

9. Elektronikgehäuse (10) nach Anspruch 8, **dadurch gekennzeichnet, dass** wenigstens einer der Scharnierzapfen (21) endseitig mit einer umlaufenden Wulst (23) versehen ist, um den Zapfen (21) in der entsprechenden Zapfenaufnahme (14, 15) des Gerätedeckels (11) oder Gerätekorpus (12) zu sichern.

10. Elektronikgehäuse (10) nach einem der Ansprüche 8 oder 9, **dadurch gekennzeichnet, dass** wenigstens einer der Scharnierzapfen (21) eine abgeflachte Profilform aufweist, wobei die abgeflachte Fläche (24) in der als Langloch (14) ausgeführten Scharnierzapfenaufnahme die Langflächen des Langlochs (14) kontaktiert um die translatorische Verschiebung des Scharnierzapfens (21) im Langloch (14) zu vereinfachen.

11. Elektronikgehäuse (10) nach einem der Ansprüche 8 oder 9, **dadurch gekennzeichnet, dass** wenigstens einer der Scharnierzapfen (21) eine geriffelte Zapfenfläche (26) aufweist, um ein Anhaftung des Scharnierzapfens (21) an einer Kontaktfläche der Scharnierzapfenaufnahme (14, 15) zu reduzieren und/oder eine verbesserte Führung des Zapfens (21) während einer translatorischen Verschiebung de Zapfens (21) innerhalb seiner Aufnahme (14) zu erreichen.

12. Elektronikgehäuse (10) nach einem der vorstehenden Ansprüche 8 bis 11, **dadurch gekennzeichnet, dass** das Verbindungsteil (25) aus einem Elastomer oder einem anderen Kunststoff gefertigt ist.

13. Elektronikgehäuse (10) nach einem der vorstehenden Ansprüche, **dadurch gekennzeichnet, dass** das Elektronikgehäuse (10) aus Kunststoff besteht, insbesondere per Spritzguss hergestellt ist, und/oder eine Abdichtung zwischen Gehäusedeckel (11) und Gehäusekorpus (12) realisiert ist, die die Schutzklasse IPX4 erfüllt.

14. Elektronikgehäuse (10) nach einem der vorstehenden Ansprüche, **dadurch gekennzeichnet, dass** im Gehäusedeckel (12) ein oder mehrere Elektronickomponenten (13) integriert sind, insbesondere wenigstens ein Anzeige- und/oder Bedienelement, und die Elektronikkomponenten (13) unabhängig von der Deckelstellung über wenigstens ein Kabel, insbesondere Flachbandkabel, mit der Elektronik im Gehäusekorpus (11) verbunden bleibt.

15. Rotationsmaschine, bevorzugt Pumpe, besonders bevorzugt Kreiselpumpe, mit einem am Pumpengehäuse (1, 2) montierten Elektronikgehäuse (10) nach einem der vorstehenden Ansprüche.
